# EUROPEAN PATENT APPLICATION

(11) **EP 2 701 368 A1**
(43) Date of publication of application: **26.02.2014**
(21) Application number: 13753079.6
(22) Date of filing: 09.01.2013
(51) Int. Cl.: H04M 1/02, H01R 13/66, H01R 12/71

(54) **WIRELESS TERMINAL DEVICE**

(30) Priority: 29.06.2012 CN 201210222825
(71) Applicant: Huawei Device Co., Ltd., Longgang District Shenzhen Guangdong 518129 (CN)
(72) Inventor: ZHAO, Shuai, Guangdong 518129 (CN); PENG, Xiangmin, Guangdong 518129 (CN)
(74) Representative: Goddar, Heinz J.
(86) International application number: PCT/CN2013/070236
(87) International publication number: WO 2014/000433

(57) **Abstract**

Embodiments of the present invention provide a wireless terminal device, including: a subscriber card holder, a mainboard, a secondary board, and a housing, where the mainboard, the secondary board, and the subscriber card holder are located in the housing, the subscriber card holder is disposed on the secondary board, the secondary board is fixed to the housing so that the subscriber card holder is separated from the mainboard spatially, and the secondary board is connected to the mainboard in a low thermal conductivity manner. According to the wireless terminal device disclosed in the embodiments of the present invention, a subscriber card and a subscriber card holder are fixed to a housing, so that the subscriber card and the subscriber card holder are isolated from a mainboard spatially. This effectively prevents heat generated by an exothermic component on the mainboard from being conducted to the subscriber card, thereby preventing deformation of the subscriber card.

## Description

### TECHNICAL FIELD

The present invention relates to the field of wireless communications technologies, and in particular, to a wireless terminal device.

### BACKGROUND

Wireless terminal devices, such as a mobile phone and a wireless network card (such as a USB modem), develop toward better portability, which requires these terminal devices to have a smaller size and more compact inner structure. An existing wireless terminal device generally integrates numerous functions and features a strong computing capability, which increases power consumption of the wireless terminal device. How to effectively control the operating temperature of a wireless terminal device with a compact structure, especially the problem of heat dissipation of a subscriber card such as a subscriber identity module (Subscriber Identity Module, SIM) card and a universal subscriber identity module (Universal Subscriber Identity Module, USIM) card, has become a technical challenge. A subscriber card is installed on a subscriber card holder, and the subscriber card holder is installed on a mainboard together with other exothermic components such as a processing chip and a radio frequency circuit. Therefore, heat generated by the other exothermic components during operation is easily conducted to the subscriber card through the mainboard and the subscriber card holder. Take a SIM card as an example, when the temperature of the SIM card exceeds 85°C, its plastic part may be softened. As a result, the SIM card deforms, and the SIM card cannot operate normally due to poor contact with the mainboard.

### SUMMARY

Embodiments of the present invention provide a wireless terminal device, so as to solve the problem that a wireless terminal device during operation easily deforms due to heat.

In one aspect, an embodiment of the present invention provides a wireless terminal device, including: a subscriber card holder, a mainboard, a secondary board, and a housing, where the mainboard, the secondary board, and the subscriber card holder are located in the housing, the subscriber card holder is disposed on the secondary board, the secondary board is fixed to the housing so that the subscriber card holder is separated from the mainboard spatially, and the secondary board is connected to the mainboard in a low thermal conductivity manner.

In a first possible implementation manner, the secondary board is fixed to the housing, which is specifically as follows: a first baffle is disposed in the housing, and the first baffle fixes the secondary board.

In a second possible implementation manner, the secondary board is fixed to the housing, which is specifically as follows: the secondary board is adhered to the housing, so that the secondary board is fixed to the housing.

In a third possible implementation manner, the secondary board is fixed to the housing, which is specifically as follows: the secondary board is fixed to the housing by using a screw, a heat stake, or a snap.

In a fourth possible implementation manner, the secondary board is fixed to the housing, which is specifically as follows: the subscriber card holder is adhered to the housing, and the secondary board is fixed to the housing through the subscriber card holder.

According to the first, second, third, and fourth possible implementation manners, the secondary board is connected to the mainboard in a low thermal conductivity manner, which is specifically as follows: the secondary board is connected to the mainboard through an FPC, a cable, an ejector pin, or a snap dome.

In the wireless terminal device disclosed in the embodiment of the present invention, a subscriber card holder is disposed on a secondary board, and the secondary board is fixed to a housing, so that the subscriber card holder is isolated from a mainboard spatially. This can effectively prevent heat generated by an exothermic component on the mainboard from being conducted to a subscriber card when the subscriber card is inserted into the subscriber card holder and the wireless terminal device is operating normally, thereby preventing deformation of the subscriber card.

In another aspect, an embodiment of the present invention further provides another wireless terminal device, including: a subscriber card holder, a mainboard, and a housing, where the mainboard and the subscriber card holder are located in the housing, the subscriber card holder is fixed to the housing so that the subscriber card holder is separated from the mainboard spatially, and the subscriber card holder is connected to the mainboard in a low thermal conductivity manner.

In a first possible implementation manner, the subscriber card holder is fixed to the housing, which is as follows:
the subscriber card holder is adhered to the housing; or
a second baffle is disposed in the housing, and the second baffle fixes the subscriber card holder.

According to the first possible implementation manner, the subscriber card holder is connected to the mainboard in a low thermal conductivity manner, which is specifically as follows: the subscriber card holder is connected to the mainboard through an FPC, a cable, an ejector pin, or a snap dome.

In the wireless terminal device disclosed in the embodiment of the present invention, a subscriber card holder is fixed to a housing, so that the subscriber card holder is isolated from a mainboard spatially. This can effectively prevent heat generated by an exothermic component on the mainboard from being conducted to a subscriber card when the subscriber card is inserted into the subscriber card holder and the wireless terminal device is operating normally, thereby preventing deformation of the subscriber card.

### BRIEF DESCRIPTION OF DRAWINGS

FIG. 1 is a schematic structural diagram of a wireless terminal device according to an embodiment of the present invention;
FIG. 2 is a schematic structural diagram of another wireless terminal device according to an embodiment of the present invention;
FIG. 3 is a schematic structural diagram of another wireless terminal device according to an embodiment of the present invention;
FIG. 4 is a schematic structural diagram of another wireless terminal device according to an embodiment of the present invention;
FIG. 5 is a schematic structural diagram of another wireless terminal device according to an embodiment of the present invention;
FIG. 6 is a schematic structural diagram of another wireless terminal device according to an embodiment of the present invention;
FIG. 7 is a schematic structural diagram of another wireless terminal device according to an embodiment of the present invention;
FIG. 8 is a schematic structural diagram of another wireless terminal device according to an embodiment of the present invention;
FIG. 9 is a schematic structural diagram of another wireless terminal device according to an embodiment of the present invention;
FIG. 10 is a schematic structural diagram of another wireless terminal device according to an embodiment of the present invention; and
FIG. 11 is a schematic structural diagram of another wireless terminal device according to an embodiment of the present invention.

### DESCRIPTION OF EMBODIMENTS

To make the objectives, technical solutions, and advantages of the present invention more comprehensible, the following further describes specific embodiments of the present invention with reference to the accompanying drawings. Apparently, the described embodiments are merely a part rather than all of the embodiments of the present invention. All other embodiments obtained by persons of ordinary skill in the art based on the embodiments of the present invention without creative efforts shall fall within the protection scope of the present invention.

First, it should be noted that, a subscriber card described in the embodiments of the present invention includes but is not limited to a card configured to store subscriber information for wireless communication and implement wireless communication, such as a SIM card and a USIM card. A wireless terminal device described in the embodiments of the present invention includes but is not limited to a terminal device, such as a USB modem, a mobile phone, a tablet, or a wireless router, that is disposed with a subscriber card holder and is capable of reading a subscriber card. In the following embodiments, a USB modem is taken as an example for description, but this does not impose a limitation on the present invention.

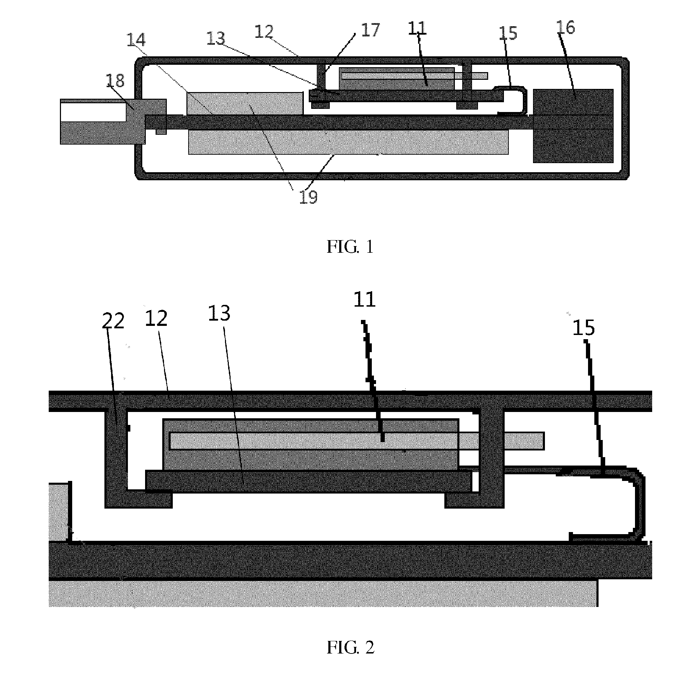

Referring to FIG. 1, an embodiment of the present invention provides a USB modem, including: a subscriber card holder 11, a mainboard 14, a secondary board 13, and a housing 12, where the mainboard 14, the secondary board 13, and the subscriber card holder 11 are located in the housing 12, the subscriber card holder 11 is disposed on the secondary board 13, the secondary board 13 is fixed to the housing 12 so that the subscriber card holder 11 is separated from the mainboard 14 spatially, and the secondary board 13 is connected to the mainboard 14 in a low thermal conductivity manner.

As can be seen from the above, in the wireless terminal device disclosed in the embodiment of the present invention, the subscriber card holder 11 is disposed on the secondary board 13, and the secondary board 13 is fixed to the housing 12. In this way, the subscriber card holder is isolated from the mainboard 14 spatially, and air is used as a good heat insulation medium, thereby effectively preventing deformation of a subscriber card due to heat, which is different from a situation in the prior art where a subscriber card holder 11 is physically connected to a mainboard 14, consequently a large amount of heat generated by the mainboard 14 is conducted to the subscriber card holder 11, and therefore a subscriber card deforms due to the heat. Meanwhile, in the embodiment of the present invention, the subscriber card holder 11 is not disposed on the mainboard 14, which can effectively save the space of the mainboard and reduce the size of the wireless terminal device.

The subscriber card holder 11 may be used for inserting a subscriber card, such as a SIM card and a USIM card, and the subscriber card holder 11 may be welded on the secondary board 13. The mainboard 14 and the secondary board 13 may be printed circuit boards (Printed circuit board, PCB). The mainboard 14 may bear an exothermic component 19, where the exothermic component 19 includes a component that generates a relatively large amount of heat when the USB modem is operating, such as a baseband chip and a radio frequency chip. The USB modem may further include other parts such as a USB connector 18 and an antenna 16, where the USB connector 18 and the antenna 16 are separately connected to the mainboard 33. There is some space between the secondary board 13 and the mainboard 14, and the secondary board 13 is electrically connected to the mainboard 14 in a low thermal conductivity manner, so as to exchange signals between the subscriber card holder 11 on the secondary board 13 and the mainboard 14. The connection in a low thermal conductivity manner may be a connection manner using an FPC, a cable, an ejector pin, or a snap dome. The connection in a low thermal conductivity manner features a small contact area and a low thermal conductivity compared with the connection manner of directly installing a secondary board on a mainboard or connecting a secondary board and a mainboard through a board-to-board connector. The subscriber card holder 11 may be disposed on the side of the secondary board 13 facing the mainboard 14 or may be disposed on the other side.

Optionally, a screw 17 is disposed in the housing 12. As shown in FIG. 1, the screw 17 may pass through the secondary board 13 and fix the secondary board 13 to the housing 12.

Optionally, as shown in FIG. 2, a first baffle 22 may extend inward from the housing 12. The first baffle 22 blocks the secondary board 13 and fixes the secondary board 13 to the housing 12.

Optionally, the secondary board 13 may be adhered to the housing 12 by using a double faced adhesive tape or glue, so that the secondary board is fixed to the housing 12.

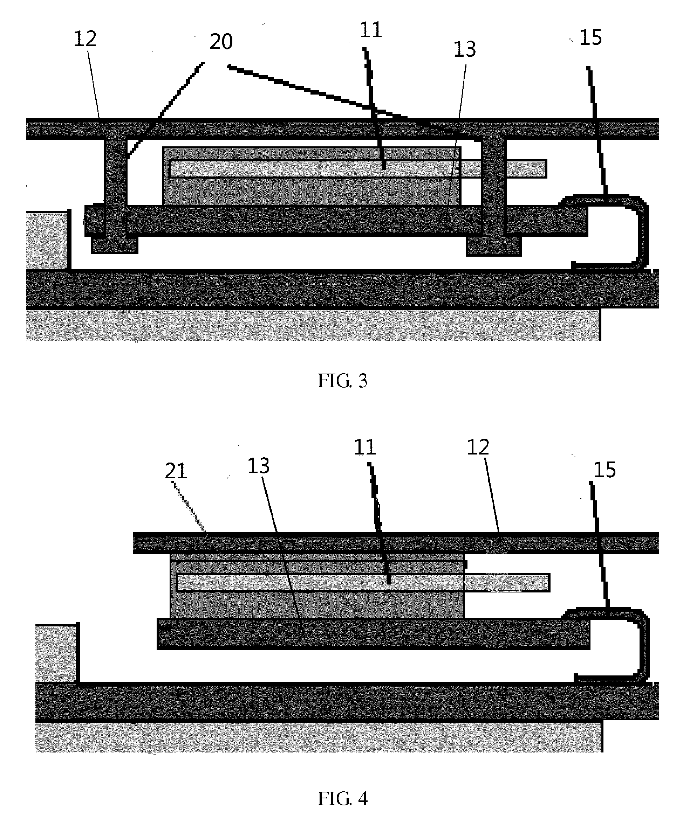

Optionally, as shown in FIG. 3, the secondary board 13 may be fixed to the housing 12 by using a heat stake 20 or a snap.

Optionally, as shown in FIG. 4, the secondary board 13 may be fixed to the housing through the subscriber card holder 11, and the subscriber card holder 11 is adhered to the housing 12 by using a double faced adhesive tape 21 or glue.

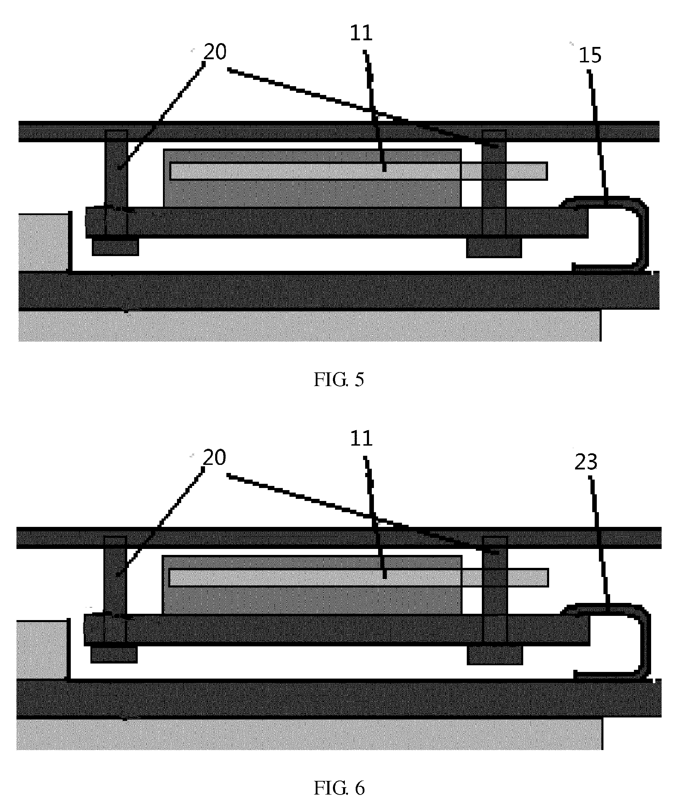

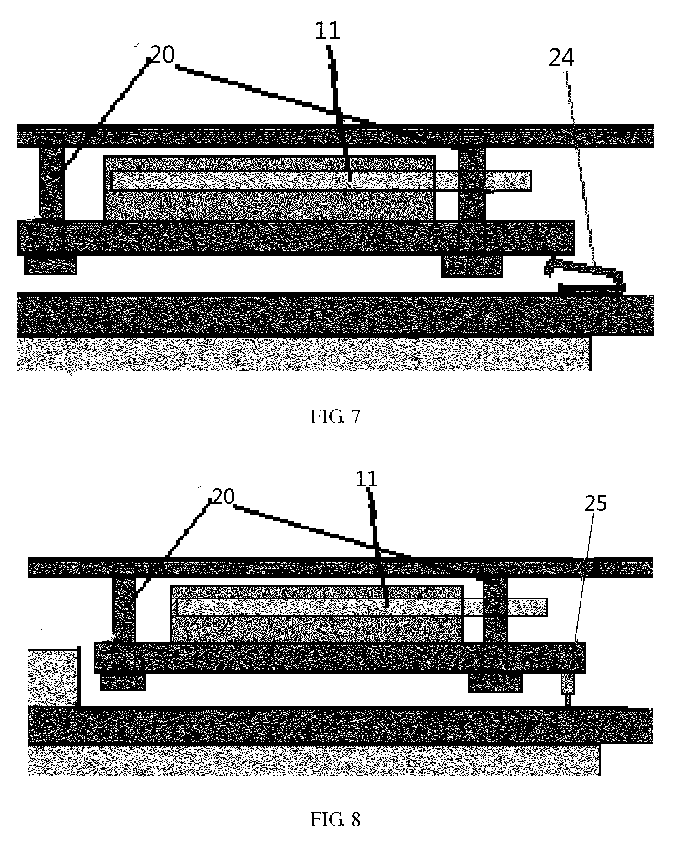

Optionally, as shown in FIG. 5, FIG. 6, FIG. 7, and FIG. 8, the secondary board may be connected to the mainboard 14 through a flexible printed circuit (Flexible Printed Circuit, FPC) 15, a cable 23, an ejector pin 24, or a snap dome 25, so as to exchange signals between the subscriber card holder 11 on the secondary board 13 and the mainboard 14. The connection to the mainboard 14 through the ejector pin 24 or the snap dome 25 simplifies manufacturing techniques and reduces the cost. The FPC 15, the cable 23, the ejector pin 24, or the snap dome 25 may be welded to the mainboard and the subscriber card holder, or, the FPC 15 or the cable 23 may be connected to the mainboard and the subscriber card holder through a connector.

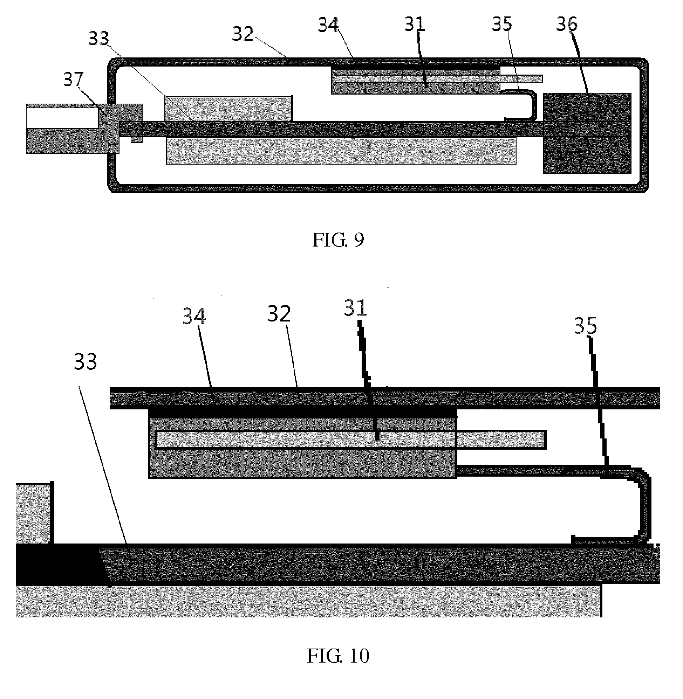

Referring to FIG. 9, an embodiment of the present invention further provides a USB modem, including: a subscriber card holder 31, a mainboard 33, and a housing 32, where the mainboard 33 and the subscriber card holder 31 are located in the housing 32, the subscriber card holder 31 is fixed to the housing 32 so that the subscriber card holder 31 is separated from the mainboard 33 spatially, and the subscriber card holder 31 is connected to the mainboard 33 in a low thermal conductivity manner.

As can be seen from the above, in the wireless terminal device disclosed in the embodiment of the present invention, the subscriber card holder 31 is fixed to the housing 32. In this way, the subscriber card holder 31 is isolated from the mainboard 33 spatially, and air is used as a good heat insulation medium, thereby effectively preventing deformation of a subscriber card due to heat, which is different from a situation in the prior art where a subscriber card holder 31 is physically connected to a mainboard 33, consequently a large amount of heat generated by the mainboard 33 is conducted to the subscriber card holder 31, and therefore a subscriber card deforms due to the heat. Meanwhile, in the embodiment of the present invention, the subscriber card holder 31 is not disposed on the mainboard 33, which can effectively save the space of the mainboard and reduce the size of the wireless terminal device. In addition, in the embodiment of the present invention, another part, such as a secondary board, is not required for fixing the subscriber card holder 31, which can further reduce the cost and the occupied space.

The subscriber card holder 31 may be used for inserting a subscriber card, such as a SIM card and a USIM card. The mainboard 33 may be a printed circuit board (Printed circuit board, PCB), and the mainboard 33 may bear an exothermic component 38, where the exothermic component 38 includes a component that generates a relatively large amount of heat when the USB modem is operating, such as a baseband chip and a radio frequency chip. The USB modem may further include other parts such as a USB connector 37 and an antenna 36, where the USB connector 37 and the antenna 36 are separately connected to the mainboard 33. There is some space between the subscriber card holder 31 and the mainboard 33, and the subscriber card holder 31 is electrically connected to the mainboard 33 in a low thermal conductivity manner, so as to exchange signals between the subscriber card holder 31 and the mainboard 33. The connection in a low thermal conductivity manner may be a connection manner using an FPC, a cable, an ejector pin, or a snap dome. The connection in a low thermal conductivity manner features a small contact area and a low thermal conductivity compared with the connection manner of directly installing a secondary board on a mainboard or connecting a secondary board to a mainboard through a board-to-board connector.

Optionally, the subscriber card holder 31 may be connected to the mainboard 33 through an FPC 35 or a cable, so as to exchange signals between the subscriber card holder 31 and the mainboard 33. The FPC 35 or the cable may be welded to the mainboard and the subscriber card holder, or, the FPC 35 or the cable may be connected to the mainboard and the subscriber card holder through a connector. The subscriber card holder 31 may also be connected to the mainboard through a snap dome or an ejector pin, which will not be described in detail herein again.

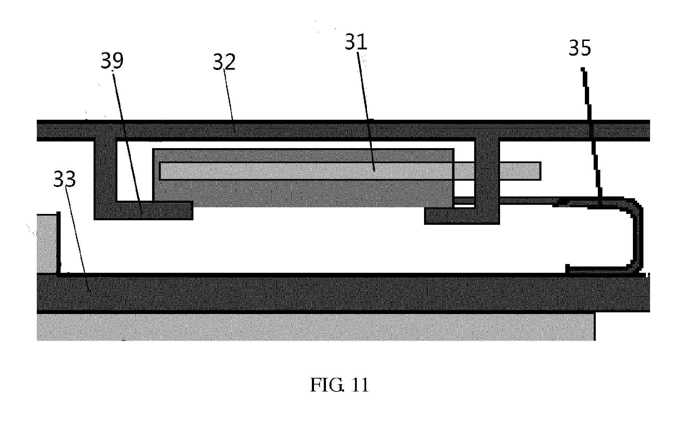

Optionally, as shown in FIG. 11, a second baffle 39 may extend inward from the housing 32. The second baffle 39 blocks the subscriber card holder 31 and fixes the subscriber card holder 31 to the housing 32.

Optionally, as shown in FIG. 10, the subscriber card holder 31 may be adhered to the housing 32 by using a double faced adhesive tape 34 or glue, so as to be fixed to the housing 32.

In the foregoing embodiments, the descriptions of the embodiments have respective focuses. For a part that is not described in detail in a certain embodiment, reference may be made to related descriptions in other embodiments.

It should be understood by persons skilled in the art that, the accompanying drawings are merely schematic diagrams of exemplary embodiments, and components in the accompanying drawings are not necessarily required in implementing the present invention.

The foregoing embodiments are merely intended for describing the technical solutions of the present invention rather than limiting the present invention. Although the present invention is described in detail with reference to the foregoing embodiments, persons of ordinary skill in the art should understand that they may still make modifications to the technical solutions described in the above embodiments or make equivalent replacements to some technical features thereof, as long as such modifications or replacements do not cause corresponding technical solutions to depart from the scope of the technical solutions of the embodiments of the present invention.

## Claims

1. A wireless terminal device, comprising: a subscriber card holder, a mainboard, a secondary board, and a housing, wherein the mainboard, the secondary board, and the subscriber card holder are located in the housing, the subscriber card holder is disposed on the secondary board, the secondary board is fixed to the housing so that the subscriber card holder is separated from the mainboard spatially, and the secondary board is connected to the mainboard in a low thermal conductivity manner.

2. The wireless terminal device according to claim 1, wherein that the secondary board is fixed to the housing is specifically as follows: a first baffle is disposed in the housing, and the first baffle fixes the secondary board.

3. The wireless terminal device according to claim 1, wherein that the secondary board is fixed to the housing is specifically as follows: the secondary board is adhered to the housing, so that the secondary board is fixed to the housing.

4. The wireless terminal device according to claim 1, wherein that the secondary board is fixed to the housing is specifically as follows: the secondary board is fixed to the housing by using a screw, a heat stake, or a snap.

5. The wireless terminal device according to claim 1, wherein that the secondary board is fixed to the housing is specifically as follows: the subscriber card holder is adhered to the housing, and the secondary board is fixed to the housing through the subscriber card holder.

6. The wireless terminal device according to any one of claims 1 to 5, wherein that the secondary board is connected to the mainboard in a low thermal conductivity manner is specifically as follows: the secondary board is connected to the mainboard through an FPC, a cable, an ejector pin, or a snap dome.

7. The wireless terminal device according to any one of claims 1 to 6, wherein the wireless terminal device is a USB modem, a mobile phone, a tablet, or a wireless router.

8. A wireless terminal device, comprising: a subscriber card holder, a mainboard, and a housing, wherein the mainboard and the subscriber card holder are located in the housing, the subscriber card holder is fixed to the housing so that the subscriber card holder is separated from the mainboard spatially, and the subscriber card holder is connected to the mainboard in a low thermal conductivity manner.

9. The wireless terminal device according to claim 8, wherein that the subscriber card holder is fixed to the housing is specifically as follows:
the subscriber card holder is adhered to the housing; or
a second baffle is disposed in the housing, and the second baffle fixes the subscriber card holder.

10. The wireless terminal device according to claim 8 or 9, wherein that the subscriber card holder is connected to the mainboard in a low thermal conductivity manner is specifically as follows: the subscriber card holder is connected to the mainboard through an FPC, a cable, an ejector pin, or a snap dome.

11. The wireless terminal device according to any one of claims 8 to 10, wherein the wireless terminal device is a USB modem, a mobile phone, a tablet, or a wireless router.
